# EUROPEAN PATENT SPECIFICATION

(11) **EP 0 803 589 B1**
(45) Date of publication and mention of the grant of the patent: **31.05.2000**
(21) Application number: 96117978.5
(22) Date of filing: 08.11.1996
(51) Int. Cl.: C23C 16/40, G02B 6/00, C03B 19/14

(54) **Method of manufacturing optical waveguide having no void**
Verfahren zur Herstellung eines blasenfreien Lichtwellenleiters
Procédé de fabrication d'un guide d'onde exempt d'espaces vides

(30) Priority: 09.11.1995 JP 31493595
(43) Date of publication of application: 29.10.1997
(73) Proprietor: NEC CORPORATION, Tokyo (JP)
(72) Inventor: Nishimoto, Hiroshi, Minato-ku, Tokyo (JP)
(74) Representative: Glawe, Delfs, Moll & Partner

(56) References cited:
- US-A- 5 076 654
- PATENT ABSTRACTS OF JAPAN vol. 017, no. 669 (P-1657), 9 December 1993 & JP 05 224056 A (HITACHI CABLE LTD;OTHERS: 01), 3 September 1993,
- PATENT ABSTRACTS OF JAPAN vol. 94, no. 012 & JP 06 347657 A (NEC CORP), 22 December 1994,
- PATENT ABSTRACTS OF JAPAN vol. 95, no. 006, 31 July 1995 & JP 07 077620 A (TOKAI RUBBER IND LTD), 20 March 1995,

## Description

### FIELD OF THE INVENTION

The invention relates to a method of manufacturing an optical waveguide by using quartz materials, and more particularly to a method of manufacturing an optical waveguide for optical devices of various kinds that are used in such an optical fiber network.

### BACKGROUND OF THE INVENTION

In recent years, a large capacity of an optical communication system is advanced, and a highly system having multi-functions is needed. In addition, an optical fiber network is required to be structured with low cost. An optical waveguide is indispensably necessary to be small in size, highly integrated, and low in cost, since the optical waveguide is used in an optical device such as a coupler, a switch, a filter, and a modulator. Also, the optical waveguide is used in such a functional device which comprises a semiconductor laser and a semiconductor photo detector which are mounted in the form of hybrid together with an optical device on a substrate. Research and development of these devices are actively advanced.

Presently, a quartz material, a ferroelectric material, an organic material, a semiconductor material, etc. are used as a material of the optical waveguide. Since the optical waveguide made of the quartz material has the smallest light transmission loss, an optical device having a small light transmission loss is easily realized by using the quartz material. Also, since the optical waveguide may be fabricated on a Si-substrate having a large diameter, low cost and mass-productivity are realized.

A conventional optical waveguide typically comprises a substrate and a lower clad layer, cores, and an upper clad layer which are grown on the substrate.

In order to obtain the optical waveguide having a small light transmission loss, each of the lower and upper clad layers and cores needs to have a predetermined thickness.

Presently, a flame depositing method, or chemical vapor deposition (CVD) using silane gas, chloride gas, an organic material source, etc. is used for the deposition of a quartz material.

In the flame depositing method, powders of quartz are deposited on a substrate, and the powders of quartz are heated and fused at a temperature of about 1500 °C to be transparentized, so that an optical waveguide is fabricated. For this thermal treatment, a large thermal stress is introduced in a layer of quartz, so that cracks tend to occur therein. Therefore, it is hard in the fabrication of an optical waveguide to adopt a Si-substrate having a large diameter of, for instance, 6 inches. In addition, birefringence occurs due to strains caused by the thermal stress, so that the optical characteristics are deteriorated to result in polarization dependency, etc.

On the other hand, in the CVD which uses silane gas, chloride gas, etc., it is possible to form a minute and transparent quartz layer immediately after the deposition thereof. However, when the upper clad layer is deposited to embed the two adjacent cores, the deposition rate is different at positions of a side wall, a bottom surface, and an upper corner of each of the cores. In more detail, the deposition rate is high at the upper corner of each core. As a result, a void tends to occur in the upper clad layer between the two adjacent cores.

Therefore, a void must be eliminated by reflowing the upper clad layer at a high temperature. For this process, an internal stress is increased due to the thermal treatment for the elimination of the void, in addition to a stress resided in the upper clad layer immediately after the deposition thereof. Even in the CVD, birefringence occurs due to strains caused by the stresses as explained above. As a result, the optical characteristics are deteriorated to result in polarization dependency, etc. in a resultant optical device.

As described above, a conventional method of manufacturing an optical waveguide by using a flame depositing method or CVD has disadvantages in that the below requirements are not met simultaneously;
(a) the deposition of a quartz material having a thickness necessary for the fabrication of an optical waveguide is realized on a Si-substrate of a large diameter,
(b) the optical characteristics are not deteriorated in a fabricated optical waveguide, and
(c) a void is avoided to occur in an upper clad layer between two adjacent cores.

### SUMMARY OF THE INVENTION

Accordingly, it is an object of the invention to provide a method of manufacturing an optical waveguide that is capable of concurrently depositing, on a Si-substrate having a large diameter, a quartz material layer having a thickness necessary for forming an optical waveguide, and avoiding the deterioration of the optical characteristics, and the occurrence of a void in an upper clad layer between two adjacent cores.

Other objects of the invention will become clear as the description proceeds.

According to the invention, a method of manufacturing an optical waveguide, comprises, the steps of:
forming, by using CVD, a lower clad layer on a substrate, the lower clad layer being made of a quartz material;
forming, by using CVD, a core formation layer on the lower clad layer, the core formation layer being made of a quartz material;
forming at least two cores by patterning the core formation layer; and
forming, by using CVD in which one or more organic materials are used as a source/sources, an upper clad layer on the cores and the lower clad layer, the upper clad layer being made of a quartz material which includes one or more dopants selected from phosphorus, boron, and germanium, the sources including an identical alkoxyl radical.

### BRIEF DESCRIPTION OF THE DRAWINGS

The invention will be explained in more detail in conjunction with appended drawings, wherein:
FIG. 1 is a schematic sectional view for explaining a first conventional method of manufacturing an optical waveguide;
FIG. 2 is a schematic sectional view for explaining a second conventional method of manufacturing an optical waveguide; and
FIG. 3 is a schematic sectional view for explaining a method of manufacturing an optical waveguide according to an embodiment of the invention.

### DESCRIPTION OF THE PREFERRED EMBODIMENTS

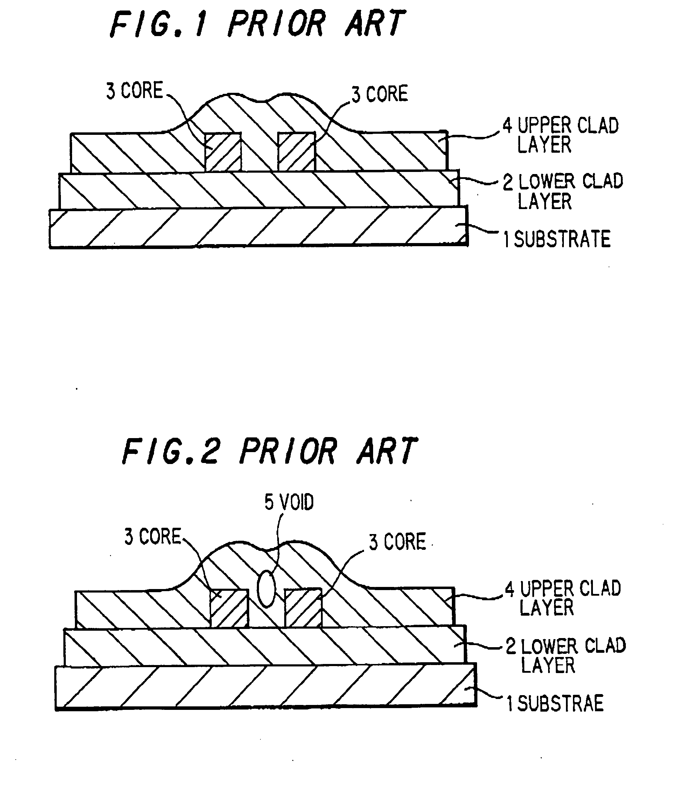

Before explaining a method of manufacturing an optical waveguide in the preferred embodiments according to the invention, the aforementioned conventional method of manufacturing an optical waveguide will be explained in FIGS. 1 AND 2.

FIG. 1 shows a first conventional optical waveguide which ordinarily comprises a substrate 1 and a lower clad layer 2, cores 3, and an upper clad layer 4 which is formed on the substrate 1. In order to obtain the optical waveguide having a small light transmission loss, each of the lower and upper clad layers 2 and 4 needs to have a thickness of above 10 µm. Also, in order to connect the cores 3, with high efficiency, to an optical fiber, each of the cores 3 needs to have a thickness of about 3 to 10 µm. Therefore, in order to obtain the optical waveguide having the small light transmission loss, three layers of the lower and upper clad layers 2 and 4 and the cores 3 need to have a total thickness of above 25 µm.

In the flame depositing method, powders of quartz are deposited on a substrate, and the powders of quartz are heated and fused at a temperature of about 1500°C to be transparentized, thereby the optical waveguide are formed. Therefore, it is easily possible to deposit the upper clad layer 4 over and between the two adjacent cores 3. However, since a large thermal stress is introduced, cracks occurs in the upper clad layer 4, etc..

On the other hand, in the CVD which uses one of silane gas, and chloride gas, etc., it is possible to form a minute and transparent quartz layer immediately after deposition. However, when the upper clad layer 4 is deposited over and between the two adjacent cores 3, the deposition rate is different at positions of a side wall, a bottom surface, and an upper corner of each of the cores 3. Particularly, the deposition rate at the upper corner of each of the cores 3 is high. As a result, as shown in FIG. 2, a void 5 occurs in the upper clad layer 4 between the two adjacent cores 3.

Therefore, in the CVD, the void is eliminated by reflowing the upper clad layer 4 at a high temperature. As a result, an internal stress which occurs in heating the upper clad layer 4 for eliminating the void is added to a stress which remains therein immediately after the deposition thereof.

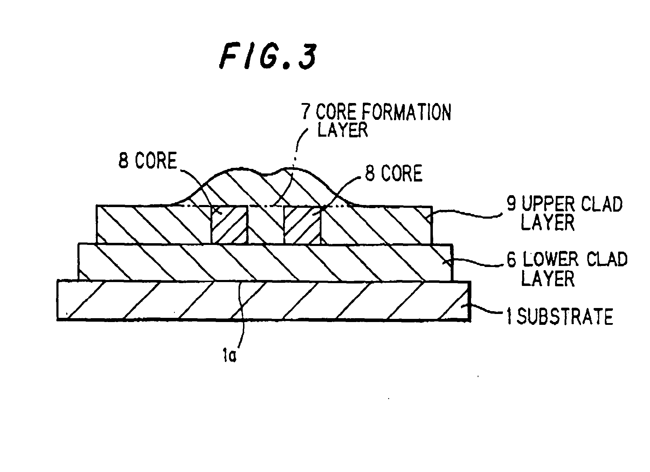

Referring to FIG. 3, the description will proceed to a method of manufacturing an optical waveguide according to an embodiment of the invention.

In FIG. 3, a substrate 1 is prepared in a known manner to have a main surface 1a. For example, the substrate 1 is made of Si. A lower clad layer 6 is formed, by using a method of the CVD, on the main surface la of the substrate 1. The lower clad layer 6 is made of a quartz material. The lower clad layer 6 has a thickness of about 10 to 20 µm. Next, a core layer 7 is formed, by the method of the CVD, on the lower clad layer 6. The core layer 7 is made of a quartz material. Next, at least two cores 8 are formed, as channels by patterning the core layer 7. Each of the cores 8 has a thickness of about 3 to 10 µm.

Next, an upper clad layer 9 is formed, by the method of the CVD that uses an organic material as a source, on the cores 8 and the lower clad layer 6. The upper clad layer 9 is made of a quartz material which includes at least one of phosphorus, boron, and germanium as a dopant, the source including alkoxyl radical. The upper clad layer 9 has a thickness of about 10 to 20 µm.

The cores 8 are made of a material, a refractive index of which is higher than that of the lower and upper clad layers 6 and 9. Each refractive index of the lower and upper clad layers 6 and 9 and the cores 8 is controlled by density of dopant. In case that the cores 8 are made of a material of the same composition as the lower and upper clad layers 6 and 9, a composition ratio of the cores 8 is different from that of the lower and upper clad layers 6 and 9.

In the preferred embodiment, the CVD in which the organic material is used as the source is one selected from an atmospheric pressure CVD (APCVD), a plasma CVD (PCVD), and a low pressure CVD (LPCVD).

The lower clad layer 6 preferably is made of nondoped SiO₂ (NSG). The lower clad layer 6 may be made of a material which includes the NSG and one or more dopants such as phosphor, boron, and germanium that are doped in the NSG. The lower clad layer 6 preferably is formed by the CVD method in which, as a source, an organic Si material such as tetraethoxysilane (Si(OC₂H₅)₄ ) and tetramethylortho-silicate (Si(OCH₃)₄) is used. In case of doping impurities in the lower clad layer, an organic material which is the same as the upper clad layer 9 is used together with the organic Si material.

The core layer 7 preferably is formed by using the CVD in which organic material is used as a source. In this event, tetraethoxysilane (Si(OC₂H₅)₄) and tetramethylortho-silicate (Si(OCH₃)₄) are used as an organic Si material. Trimethylphosphite (P(OCH₃)₃), trimethylphosphate (PO(OCH₃)₃), and triethylphosphate (PO(OC₂H₅)3) are used as an organic material for doping phosphor. Triethylborate (B(OC₂H₅)₃) and trimethylborate (B(OCH₃)₃) are used as an organic material for doping boron. Tetramethoxygermanium (Ge(OCH₃)₄) and tetraethoxygermanium (Ge(OC₂H₅)₄) are used as an organic material for doping germanium.

These organic materials suitably are selected dependently on a composition of the core 8. After each of organic materials as the source is vaporized and mixed, the organic materials are introduced in a reaction chamber. Oxygen is provided in the reaction chamber after ozonization in addition to the organic source. The core layer 7 is formed by using one of the atmospheric pressure CVD, the plasm CVD, and the low pressure CVD. The temperature of forming the core layer 7 in the reaction chamber preferably is a value of 200 to 800 °C.

When both of the lower clad layer 6 and the cores 8 are formed by the CVD in which the organic source is used, it is possible to form the lower clad layer 6 and the cores 8 without exposing the substrate 1 to the atmosphere. Also, since it is possible to form a layer which has a small stress, it is possible to form a thick layer which has a small stress in even case that a substrate having a large diameter is used. After an oxide layer is grown for the cores 8, the cores 8 are formed by patterning the core layer 7. Patterning the core layer 7 is carried out by using an etching such as RIE (Reactive Ion Etching) method and IBE (Ion Beam Etching) method.

In order to increase a refractive index, the cores 8 are made of a material which consists of the NSG and impurities doped in the NSG. Namely, the cores 8 may be made of one selected from SiO₂ including doped germanium oxide (GeO₂) that will hereafter be called GeSG, SiO2 including doped germanium oxide (GeO₂) and phosphorus oxide (P₂O₅) that will hereafter be called GePSG, SiO₂ including doped germanium oxide (GeO₂) and boron oxide (B₂O₃) that will hereafter be called GeBSG, SiO₂ including doped germanium oxide (GeO₂), phosphorus oxide, and boron oxide (B₂O₃) that will hereafter be called GeBPSG, SiO₂ including doped phosphorus oxide (P₂O₅) that will hereafter be called PSG, and SiO₂ including doped phosphorus oxide, and boron oxide that will hereafter be called BPSG.

The upper clad layer 9 is made of a material which includes the NSG and impurity (dopant). Namely, the upper clad layer 9 is made of one selected from PSG which consists of NSG including doped phosphorus oxide, glass material which consists of NSG including doped boron oxide that will hereafter be called BSG, BPSG which consists of NSG including doped phosphorus oxide and doped boron oxide, GeSG which consists of NSG including doped germanium oxide, GePSG which consists of NSG including doped germanium oxide and doped phosphorus oxide, GeBSG which consists of NSG including doped germanium oxide and doped boron oxide, and GeBPSG which consists NSG including doped germanium oxide, doped phosphorus oxide, and doped boron oxide.

The upper clad layer 9 is formed by using the CVD in which an organic material is used. The organic material of the upper clad layer 9 is the same as that of the cores 8. Namely, the glass layer is formed by introducing, in the reaction chamber, gas of tetraethoxysilane (Si(OC₂H₅)₄) or tetramethylortho-silicate (Si(OCH₃)₄), gas of at least one of an organic source for dopant, and ozone. To form the upper clad layer 9 preferably is carried out by the normal pressure CVD method. Also, to form the upper clad layer 9 is carried out by one of the plasm CVD method and the low pressure CVD method. The temperature of forming the upper clad layer 9 in the reaction chamber preferably is a value of 200 to 800 °C.

The inventor of the invention has found that the deposition rate of a quartz material at positions of a side wall, a bottom surface, and upper corners of the cores 8 is equalized, namely, the deposition rate of a quartz material at the upper corners of the cores 8 becomes slower, if each of the organic source materials includes the same alkoxyl radical when the upper clad layer 9 is formed over and between the two adjacent cores 8 which are positioned with a narrow space left therebetween.

Therefore, it is possible to embed the two adjacent cores 8 without occurrence of any void when layers are formed only by using organic sources including an identical alkoxyl radical. As a result, to reflow the upper clad layer 9 at a high temperature in the conventional method is not necessary in the invention. The quartz glass originally is formed with a low internal stress state by using the CVD in which the organic sources having an identical alkoxyl radical are used. According to the invention, since heating an upper clad layer at a high temperature is not necessary to be carried out, it is possible to derive the low internal stress state in an optical waveguide. As a result, the invention can prevent deterioration of the optical characteristics which are caused by birefringence, etc..

The upper clad layer 9 preferably is formed by at least one of trimethylphosphate (PO(OCH₃)₃), trimethylborate (B(OCH₃)₃), and tetramethoxygermanium (Ge(OCH₃)₄) as organic source materials for a dopant in case of using tetraethoxysilane (Si(OC₂H₅)₄) as a Si organic material. Also, the upper clad layer 9 preferably is formed by at least one of trimethylphosphite (P(OCH₃)₃), trimethylborate (B(OCH₃)₃), and tetramethoxygermanium (Ge(OCH₃)₄) as organic source materials for a dopant in case of using tetraethoxysilane (Si(OC₂H₅)₄) as a Si organic material. In addition, the upper clad layer 9 preferably is formed by at least one of triethylphosphate (PO(OC₂H₅)₃), triethylborate (B(OC₂H₅)₃), and tetraethoxygermanium (Ge(OC₂H₅)₄) as organic source materials for a dopant in case of using tetraethoxysilane (Si(OC₂H₅)₄) as a Si organic material.

### [ FIRST IMPLEMENTATION ]

The description will proceed to a first implementation according to the invention. The lower clad layer 6, namely, NSG is deposited on the Si substrate 1 having a diameter of 6 inches to have a thickness of 20 µm by the APCVD method in which (Si(OC₂H₅)₄) is used as the source at a deposition temperature of 400 °C. GeSG for forming the cores is deposited on the lower clad layer 6 to have a thickness of 6 µm by the APCVD method in which (Si(OCH₃)₄) and (Ge(OCH₃)₄) are used as the sources at a deposition temperature of 400 °C. The two cores 8 each of which has a width of 6 µm are formed with a space of 5 µm left therebetween 8 by patterning the GeSG layer by using RIE. Next, the upper clad layer 9, namely, PSG is deposited to have a thickness of 20 µm by the APCVD method in which (Si(OCH₃)₄) and (PO(OCH₃)₃) are used as the sources at a deposition temperature of 400 °C.

### [ SECOND IMPLEMENTATION ]

The description will proceed to a second implementation according to the invention. The lower clad layer 6 and the cores 8 are formed similarly to the first practical embodiment. The upper clad layer 6, namely, BSG is deposited to have a thickness of 20 µm by the APCVD method in which (Si(OCH₃)₄) and (B(OCH₃)₃) are used as the sources at a deposition temperature of 400 °C.

### [ THIRD IMPLEMENTATION ]

The description will proceed to a third implementation according to the invention. The lower clad layer 6, namely, NSG is deposited on the Si substrate 1 of 6 inches to have a thickness of 15 µm by the LPCVD method in which (Si(OCH₃)₄) is used as the source . GePSG for forming the cores 8 is deposited on the lower clad layer 6 to have a thickness of 5 µm by the APCVD method in which (Si(OC₂H₅)₄), (Ge(OCH₃)₄), and (PO(OCH₃)₃) are used as the source. The two cores 8 each of which has a width of 5 µm are formed with a space of 7 µm left therebetween by patterning the GeSG layer by using IBE. Next, the upper clad layer 9, namely, GePSG is deposited to have a thickness of 15 µm by the APCVD method in which (Si(OCH₃)₄), (Ge(OCH₃)₄), and (PO(OCH₃)₃) are used as the sources at a deposition temperature of 400 °C.

### [ FOURTH IMPLEMENTATION ]

The description will proceed to a fourth implementation according to the invention. The lower clad layer 6, namely, NSG is deposited on the Si substrate 1 having a diameter of 8 inches to have a thickness of 20 µm by the APCVD method in which (Si(OCH₃)₄) is used as the source. GePSG for forming the cores 8 is deposited on the lower clad layer 6 to have a thickness of 10 µm by the PCVD method in which (Si(OC₂H₅)₄), (Ge(OC₂H₅)₄), and (PO(OCH₃)₃) are used as the sources. The two cores 8 each of which has a width of 10 µm are formed with a space of 10 µm left therebetween by patterning the GePSG layer by using RIE. Next, the upper clad layer 9, namely, GeBSG is deposited to have a thickness of 20 µm by the APCVD method in which (Si(OCH₃)₄), (Ge(OC₂H₅)₄), and (B(OC₂H₅)₃) are used as the source at a deposition temperature of 400 °C.

When the Si-wafer which are processed in the first through fourth implementations cut to provide a predetermined number of optical waveguides which are then evaluated in the optical characteristics. In the evaluation, it has been found that any crack does not occur, and birefringence is not observed in the optical waveguides and that the satisfactory optical characteristics are obtained for each optical waveguide.

Although the invention has been described with respect to specific embodiment for complete and clear disclosure, the appended claims are not to be thus limited but are to be construed as embodying all modification and alternative constructions that may be occurred to one skilled in the art which fairly fall within the basic teaching here is set forth.

## Claims

1. A method of manufacturing an optical waveguide, comprising, the steps of:
forming, by using CVD, a lower clad layer (6) on a substrate (1), said lower clad layer (6) being made of a quartz material;
forming, by using CVD, a core formation layer (7) on said lower clad layer (6), said core formation layer (7) being made of a quartz material;
forming at least two cores (8) by patterning said core formation layer (7); and
forming an upper clad layer (9) on said cores (8) and said lower clad layer (6) by using CVD in which organic materials are used as sources, said upper clad layer (9) being made of a quartz material which includes one or more dopants selected from phosphorus, boron, and germanium, said sources including an identical alkoxyl radical.

2. A method of manufacturing an optical waveguide as defined in claim 1, wherein said steps of forming said lower clad (6), core formation (7) and upper clad layers (9) use CVD selected from an atmospheric pressure CVD, a plasm CVD, and a low pressure CVD.

3. A method of manufacturing an optical waveguide as defined in claim 1, wherein said step of forming said upper clad layer (9) uses said source/sources selected from trimethylphosphate (PO(OCH₃)₃), trimethylborate (B(OCH₃)₃), and tetramethoxygermanium (Ge(OCH₃)₄) and tetramethylortho-silicate (Si(OCH₃)₄).

4. A method of manufacturing an optical waveguide as defined in claim 1, wherein said step of forming said upper clad layer (9) uses said source/sources selected from trimethylphosphite (P(OCH₃)₃), trimethylborate (B(OCH₃)₃), and tetramethoxygermanium (Ge(OCH₃)₄) and tetramethylortho-silicate (Si(OCH₃)₄).

5. A method of manufacturing an optical waveguide as defined in claim 1, wherein said step of forming said upper clad layer (9) uses said source/sources selected from triethylphosphate (PO(OC₂H₅)₃), triethylborate (B(OC₂H₅)₃), and tetraethoxygermanium (Ge(OC₂H₅)₄) and tetraethoxysilane (Si(OC₂H₅)₄).

6. A method of manuffacturing an optical waveguide as defined in claim 1, wherein said steps of forming said lower clad layer (6) and said core formation layer (7) uses said source/sources selected from organic materials.

7. A method of manufacturing an optical waveguide as defined in claim 6, wherein said steps of forming said lower clad layer (6) and said core formation layer (7) use CVD selected from an atmospheric pressure CVD, a plasm CVD, and a low pressure CVD

## Patentansprüche

1. Verfahren der Herstellung eines optischen Wellenleiters mit den Schritten:
Ausbilden einer unteren Deckschicht (6) auf einem Substrat (1) mittels CVD, wobei die untere Deckschicht (6) aus einem Quarzmaterial gefertigt ist,
Ausbilden einer Kernbildungsschicht (7) auf der unteren Deckschicht (6) mittels CVD, wobei die Kernbildungsschicht (7) aus einem Quarzmaterial gefertigt ist,
Bilden von zumindest zwei Kernen (8) durch Strukturieren der Kernbildungsschicht (7) und
Ausbilden einer oberen Deckschicht (9) auf den Kernen (8) und der unteren Deckschicht (6) mittels CVD, wobei organische Materialien als Quellen verwendet werden, wobei die obere Deckschicht (9) aus einem Quarzmaterial gefertigt ist, das ein oder mehrere Dotiermittel enthält, das aus Phosphor, Bor und Germanium ausgewählt ist, wobei die Quellen ein identisches Akoxyl-Radikal einschließen.

2. Verfahren zur Herstellung eines optischen Wellenleiters nach Anspruch 1,
wobei die Schritte der Ausbildung der unteren Deckschicht (6), der Kernbildungsschicht (7) und der oberen Deckschicht (9) CVD einsetzen, das aus Atmosphärendruck-CVD, Plasma-CVD und Niederdruck-CVD ausgewählt ist.

3. Verfahren der Herstellung eines optischen Wellenleiters nach Anspruch 1,
wobei der Schritt des Bildens der oberen Deckschicht (9) eine Quelle/Quellen verwendet, die ausgewählt sind aus Trimethylphosphat (PO(OCH₃)), Trimethylborat (B(OCH₃)₃) und Tetramethoxygermanium (Ge(OCH₃)₄) und Tetramethylortho-Silicat (Si(OCH₃)₄).

4. Verfahren zum Herstellen eines optischen Wellenleiters nach Anspruch 1,
wobei der Schritt des Ausbildens der oberen Deckschicht (9) die Quelle/Quellen verwendet, die aus Trimethylphosphit (P(OCH₃)₃), Trimethylborat (B(OCH₃)₃) und Tetramethoxygermanium (Ge(OCH₃)₄) und Tetramethylortho-Silicat (Si(OCH₃)₄) ausgewählt sind.

5. Verfahren zum Herstellen eines optischen Wellenleiters nach Anspruch 1,
wobei der Schritt des Bildens der oberen Deckschicht (9) die Quelle/Quellen verwendet, die aus Triethylphosphat (PO(OC₂H₅)₃), Triethylborat (B(OC₂H₅)₃) und Tetraethoxygermanium (Ge(OC₂H₅)₄) und Tetraethoxysilan (Si(OC₂H₅)₄) ausgewählt sind.

6. Verfahren der Herstellung eines optischen Wellenleiters nach Anspruch 1,
wobei die Schritte zur Ausbildung der unteren Deckschicht (6) und der Kernbildungsschicht (7) die Quelle/Quellen verwendet, die aus organischen Materialien ausgewählt sind.

7. Verfahren zur Herstellung eines optischen Wellenleiters nach Anspruch 6,
wobei die Schritte der Ausbildung der unteren Deckschicht (6) und der Kernbildungsschicht (7) CVD verwendet, das aus Atmosphärendruck-CVD, Plasma-CVD und Niederdruck-CVD ausgewählt ist.

## Revendications

1. Procédé de fabrication d'un guide d'onde optique, comprenant les étapes de :
formation, en utilisant un dépôt chimique en phase vapeur, d'une couche de confinement inférieure (6) sur un substrat (1), ladite couche de confinement inférieure (6) étant faite d'un matériau de quartz ;
formation, en utilisant un dépôt chimique en phase vapeur, d'une couche de formation de coeur (7) sur ladite couche de confinement inférieure (6), ladite couche de formation de coeur (7) étant faite d'un matériau de quartz ;
formation d'au moins deux coeurs (8) en formant des motifs sur ladite couche de formation de coeur (7) ; et
formation d'une couche de confinement supérieure (9) sur lesdits coeurs (8) et ladite couche de confinement inférieure (6), en utilisant un dépôt chimique en phase vapeur dans lequel des matériaux organiques sont utilisés comme sources, ladite couche de confinement supérieure (9) étant faite d'un matériau de quartz qui comporte un ou plusieurs dopants choisis parmi le phosphore, le bore et le germanium, lesdites sources comportant un radical alcoxyle identique.

2. Procédé de fabrication d'un guide d'onde optique selon la revendication 1, dans lequel lesdites étapes de formation desdites couches de confinement inférieure (6), de formation de coeur (7) et de confinement supérieure (9), utilisent des dépôts chimiques en phase vapeur choisis parmi un dépôt chimique en phase vapeur à la pression atmosphérique, un dépôt chimique en phase vapeur à plasma et un dépôt chimique en phase vapeur à basse pression.

3. Procédé de fabrication d'un guide d'onde optique selon la revendication 1, dans lequel ladite étape de formation de ladite couche de confinement supérieure (9) utilise ladite/lesdites source/sources choisie(s) parmi le phosphate de triméthyle (PO(OCH₃)₃), le borate de triméthyle (B(OCH₃)₃), et le tétraméthoxygermanium (Ge(OCH₃)₄) et le tétraméthylorthosilicate (Si(OCH₃)₄).

4. Procédé de fabrication d'un guide d'onde optique selon la revendication 1, dans lequel ladite étape de formation de ladite couche de confinement supérieure (9) utilise ladite/lesdites source/sources choisie(s) parmi le phosphite de triméthyle (P(OCH₃)₃), le borate de triméthyle (B(OCH₃)₃), et le tétraméthoxygermanium (Ge(OCH₃)₄) et le tétraméthylorthosilicate (Si(OCH₃)₄).

5. Procédé de fabrication d'un guide d'onde optique selon la revendication 1, dans lequel ladite étape de formation de ladite couche de confinement supérieure (9) utilise ladite/lesdites source/sources choisie(s) parmi le phosphate de triéthyle (PO(OC₂H₅)₃), le borate de triéthyle (B(OC₂H₅)₃), et le tétraéthoxygermanium (Ge(OC₂H₅)₄) et le tétraéthoxysilane (Si(OC₂H₅)₄).

6. Procédé de fabrication d'un guide d'onde optique selon la revendication 1, dans lequel lesdites étapes de formation de ladite couche de confinement inférieure (6) et de ladite couche de formation de coeur (7) utilisent ladite/lesdites source/sources choisie(s) parmi des matériaux organiques.

7. Procédé de fabrication d'un guide d'onde optique selon la revendication 6, dans lequel lesdites étapes de formation de ladite couche de confinement inférieure (6) et de ladite couche de formation de coeur (7) utilisent des dépôts chimiques en phase vapeur choisis parmi un dépôt chimique en phase vapeur à la pression atmosphérique, un dépôt chimique en phase vapeur à plasma et un dépôt chimique en phase vapeur à basse pression.
